# EUROPEAN PATENT APPLICATION

(11) **EP 4 683 121 A1**
(43) Date of publication of application: **21.01.2026**
(21) Application number: 24189551.5
(22) Date of filing: 18.07.2024
(51) Int. Cl.: H01R 9/24, H01R 12/57, H01R 12/73, H01R 12/91, H01R 13/24, H05K 1/00, H01R 12/71, H01R 12/72

(54) **ELECTRICAL CONNECTOR MODULES, ASSEMBLIES, AND KITS**

(71) Applicant: TE Connectivity Solutions GmbH, 8200 Schaffhausen (CH)
(72) Inventor: MOLITOR, Stefan, 73099 Adelberg (DE); KAMINSKI, Stephen, 73099 Adelberg (DE); GAVANDA, Sebastian, 73099 Adelberg (DE)
(74) Representative: Grünecker Patent- und Rechtsanwälte PartG mbB

(57) **Abstract**

A connector module (100) is disclosed, including a terminal (110) and housing subassembly (170). The terminal (110) includes a contact zone (130) configured for reversibly and slidingly engaging, along a sliding direction (102), an electrically contacting connector, particularly a complementary contact zone thereof. The contact zone (130) includes at least one of: a first electrical contact surface (131) which is rigid, a second electrical contact surface (132) which is elastically movable, and a third surface (133) which is elastically movable. A kit is disclosed, that includes at least one connector module (100), and end caps, which attach to the housing subassembly (170).

## Description

Electrical connectors are used, for example, to contact circuit boards. Connectors can have one or more contact elements for forming one or more electrical connections. Some connectors can be used repeatedly, e.g. for disconnecting and reconnecting, or can be used flexibly with many other different types of electrical components.

Components that allow users freedom to make changes to the design in order to make a wider range of electrical devices are desired. It is desirable to be able to use the same component, such as a connector and/or connector module, to make a variety of different types of connectors, e.g. having a variable number of connectors. The connector modules and assemblies thereof that are described herein can be used for making a variety of different types of connectors, e.g. having a variable number of connections. It is desirable to keep manufacturing costs low and/or simplify assembly and/or disassembly procedures. The ability to use the same connector module to make variable kinds of connectors can reduce manufacturing costs, due to the economy of scale.

A connector module for contacting an electrically contacting connector is disclosed, including a terminal. The terminal includes a contact zone configured for reversibly and slidingly engaging, along a sliding direction, the electrically contacting connector, particularly a complementary contact zone thereof. The contact zone includes at least one or two of a first electrical contact surface which is rigid, a second electrical contact surface which is elastically movable, and a third surface which is elastically movable. Providing a connector module with at least one contact surface and at least one other surface which can be for electrical contact, can aid in creating robust electrical connections. The surfaces can be accessible from the top of the module. The access can be unobstructed. This can aid in providing redundancy in the electrical connections, aiding in providing a capability of making low resistance and/or robust electrical contact, e.g. resistant to vibration.

The connector modules and assemblies thereof can include the following further developments and/or embodiments, which can be combined singly or multiply, independently of each other unless indicated otherwise, for further embodiments. The invention is defined by the claims.

A connector module for contacting an electrically contacting connector is disclosed, including: a terminal. The terminal includes a contact zone configured for reversibly and slidingly engaging, along a sliding direction, the electrically contacting connector, particularly a complementary contact zone thereof. The contact zone includes at least one of a first electrical contact surface which is rigid, a second electrical contact surface which is elastically movable, and a third surface which is elastically movable.

The second electrical contact surface and the third surface can be elastically movable along a contact direction perpendicular to the sliding direction and perpendicular to a lateral direction.

This orientation can allow for a contact for that aids in maintaining surface-to-surface contact. This can aid in producing a robust electrical connection with low resistance. The terminal can include at least one spring section for providing elasticity along the contact direction to at least one of the second electrical contact surface and the third surface.

The third surface can extend outward along the contact direction farther than any of: the first electrical contact surface or the second electrical contact surface. This can allow the third surface to protect the other surfaces when the module is slid against another surface, such as during engagement/disengagement of the module with another mating connector. In a relaxed state of the terminal, the third contact surface can extend outward along the contact direction farther than any of the first electrical contact surface or the second electrical contact surface. In a compressed state of the terminal, the third electrical contact surface can be closer to an imaginary plane that includes the sliding direction and the first electrical contact surface than in the relaxed state. This can allow for a contact for that aids in maintaining surface-to-surface contact. The imaginary plane can be perpendicular to the contact direction.

The contact zone can include an inclined surface, which, when viewed along the sliding direction, inclines upward in the contact direction toward at least one of the second electrical contact surface and the third surface. This can provide for a smooth motion of engagement/disengagement. This can reduce wear or breakage during engagement/disengagement.

The third surface can extend higher than the first contact surface in the contact direction. This can allow the third surface to better protect the other surfaces, e.g. acting as a sacrificial surface and/or acting to clean the complementary contact, e.g. the device being mated with the module.

The second electrical contact surface can be at least one of: laterally offset from the third surface in a lateral direction perpendicular to the sliding direction, or vertically offset below the third surface along the contacting direction. This can allow the third surface to protect the second, while allowing the second to act as a conductive contact.

The module can include a conductor, such as a serpentine conductor and/or monolithic conductor. The contact zone, at a first end of the conductor, can be electrically connected by the conductor to a second end of the conductor. The second end can be configured for soldering to a face of a circuit board. The second end of the conductor can extend out of a second opening of a housing subassembly. The conductor can allow the contact zone to be used to make a connection with another part of another circuit, such as that of a circuit board.

The module can include a second terminal, including a second contact zone for reversibly and slidingly engaging, along the sliding direction, with a complementary contact zone of a second connector. The second contact zone can include at least one of: a fourth electrical contact surface which is rigid, a fifth electrical contact surface which is elastically movable, or a sixth surface which is elastically movable. A second terminal can provide additional contacting capabilities between components, e.g. between a circuit board (such as the same circuit board as previously mentioned) and another connector. The second terminal can includes a second end which is configured for soldering to the face of a circuit board.

The module can include a housing subassembly, including a wall including a recessed structure therein, the recessed structure holding the terminal. A recessed structure can allow easy manufacturing. The recessed structure in the wall can provide for a compact design. The housing subassembly can include an opening through which the terminal extends toward the second contact surface and third surface. The opening can allow for a compact design and/or allow for the second surface to make electrical contact with another device.

The module can have a relaxed state in which: the terminal extends out of the opening, and the second electrical contact surface and the third surface are outside of the opening of the housing subassembly. This can allow access to the contact surfaces.

The opening can be at a top surface of the housing subassembly which is perpendicular to the wall. This can allow access at one side of the module. The housing subassembly can include an electrically insulative material. This can allow electrical insulation between the module and any other modules. A second end of the terminal can extend outward from a second opening of the housing subassembly. This can allow electrical access to the second end. The second end can be configured for soldering to a circuit board.

The recessed structure can include a partial cavity. This can allow the housing subassembly to accommodate the conductor, or other components. The at least one spring section of the terminal can be in the partial cavity. The spring section can be movable in the partial cavity. The cavity can allow the spring to operate, while protecting it at least partially from the environment. The partial cavity can connect to the opening. This can allow the conductor that may include the spring portion to be connected to the accessible contact and/or other surfaces at the contact zone.

The wall can be structured for friction fitting with an opposite structure. This can allow the housing subassembly to be attached to other components, e.g. for forming a complete housing and/or contact assembly. An opposite wall of the housing subassembly can include the opposite structure. This can allow multiple modules to be used in cooperation to form more complex devices, such as a multi-terminal contact assemblies.

A connector assembly is disclosed herein, including a first connector module and a second connector module. The first connector module and the second connector module can be reversibly electrically mated at a contact zone of the first connector module and a second contact zone of the second connector module. The first and second electrical contact surfaces of the first connector module electrically contact, respectively, the fifth and fourth electrical contact surfaces of the second connector module. This can allow for the design of complex connector assemblies.

A connector assembly is disclosed herein, including: at least one connector module; a first end cap attached to the wall of the module(s); and a second end cap attached to the opposite side of the assembly from the wall. The end caps can form an interference fit with the housing subassembly. The first end cap and the second end cap can include respective feet for attachment to a circuit board, such as by soldering. This can allow for the design of complex connector assemblies.

A kit for forming an electrical connector assembly for connecting to a circuit board is disclosed herein, including at least one connector module; and a first end cap configured to attach to a wall of a housing subassembly of the module; and a second end cap configured to attach to an opposite wall of the housing subassembly. This can allow for the design of complex connector assemblies. The end caps can be configured to form an interference fit with the housing subassembly, such as the wall and opposite wall thereof. This can provide for ease of manufacturing. A kit aids in the flexibility of downstream design of a device that uses electrical connections, including connections to circuit boards such as printed circuit boards (PCBs). A manufacturer or user of the kit can adapt the configuration according to immediate needs. Modular components, and kits including modular components, can allow users freedom to make design changes to make a wider range of electrical devices.

Herein "and/or" means at least one of the listed elements. For example, "A and/or B" means: only A; only B, at least A; at least B; or at least A and B. For example, "X, Y, and/or Z" means: only X; only Y; only Z; at least X; at least Y; at least Z; only X and Y; only X and Z; only Y and Z; only X, Y, and Z; at least X and Y; at least X and Z; at least Y and Z; or at least X, Y, and Z. Herein an "(s)" at the end of a word means one or more; for example a hole(s) is one or more holes.

Herein, directions are defined as follows. The X-direction is a height, and can be the direction of electrical contact between mating connectors. The Y- direction is a depth, and can be along the direction of sliding engagement of mating connectors; e.g. two adjacent surfaces may slide against each other, and provide a reversible sliding (sliding along the Y-direction) engagement that includes electrical contact, in the X-direction, between mating connectors. The Z- direction is a lateral and/or width direction. Adjacent modules can mechanically connect along this direction. The Z-direction can be perpendicular to a wall of a housing subassembly of the module.

Herein, to extend and/or move in a particular direction can mean that the direction of extension and/or movement has a component in the particular direction. For example, moving in the X-direction can mean moving with a component in the X-direction. The particular direction can have a component in the particular direction (e.g. X-direction) of at least 90%, at least 95%, or at least 99% compared to the other orthogonal directions (e.g. Y and Z-directions). The % can be determined by the dot product of a unit vector of the particular direction and the orthonormal unit vector directions.

Herein, contact direction and contacting direction can be used interchangeably. Herein "module" can be used interchangeably with "connector module" and "contact module." Herein "spring section" and "spring portion" can be used interchangeably.

Herein, "first surface," "second surface," "fourth surface," and "fifth surface" can be electrical contact surfaces, for forming electrically conductive connections. Third and sixth surfaces may be the surface of an electrical conductor or may be the surface of a coating or the like, which may be over a conductor, e.g. the conductor of a terminal. A coating is not necessary. The third and sixth surfaces can protect, respectively, the second and fifth surfaces.

Herein, the term "complementary contact zone" can be used to mean a contact zone of a connector and/or connector module that is structured to mate with another contact zone. Depending on context, a first, second, third, or other enumerated "contact zone" can be a "complementary contact zone." For example, a "first contact zone" can be structured to act as a "complementary contact zone" for a "second contact zone," and vice versa. A "contact zone" of a first connector or connector module can mate with a second connector or module, such that the contact zone of the second connector and/or module can be referred to as a "complementary contact zone" to the contact zone of the first.

Herein, a second connector can be a second connector module, such as a second connector module. For example, a connector module can be connected to a second connector and/or identical connector module.

Herein, where an indentation is mentioned, a recess can be used, e.g. a recess and/or pocket at the top surface of the housing subassembly described herein.

In the following, the invention is described in more detail by means of embodiments with reference to the attached figures. In the figures, elements which correspond to one another in terms of structure and/or function are provided with the same reference signs.

The combinations of features shown and described in the individual embodiments are for explanatory purposes only. According to the above explanations, a feature of an embodiment can be omitted if its technical effect is not important for a particular application. Conversely, according to the above explanations, a further feature can be added to an embodiment if its technical effect should be advantageous or necessary for a particular application.

In the following, several examples are described.

### In the figures:

- Fig. 1: shows a connector module, according to embodiments,
- Fig. 2: shows a connector module, according to embodiments,
- Fig. 3: shows, according to embodiments, a disengaged connector assembly,
- Fig. 4: shows, according to embodiments, an engaged connector assembly,
- Fig. 5: shows, according to embodiments, a connector assembly,
- Fig. 6: shows, according to embodiments, a connector assembly,
- Fig. 7: shows, according to embodiments, connector assemblies,
- Fig. 8: shows, according to embodiments, a connector assembly,
- Fig. 9: shows a connector assembly, according to embodiments,
- Fig. 10: shows an endcap, according to an embodiment,
- Fig. 11: shows an endcap, according to an embodiment, and
- Fig. 12: shows a kit, according to an embodiment.

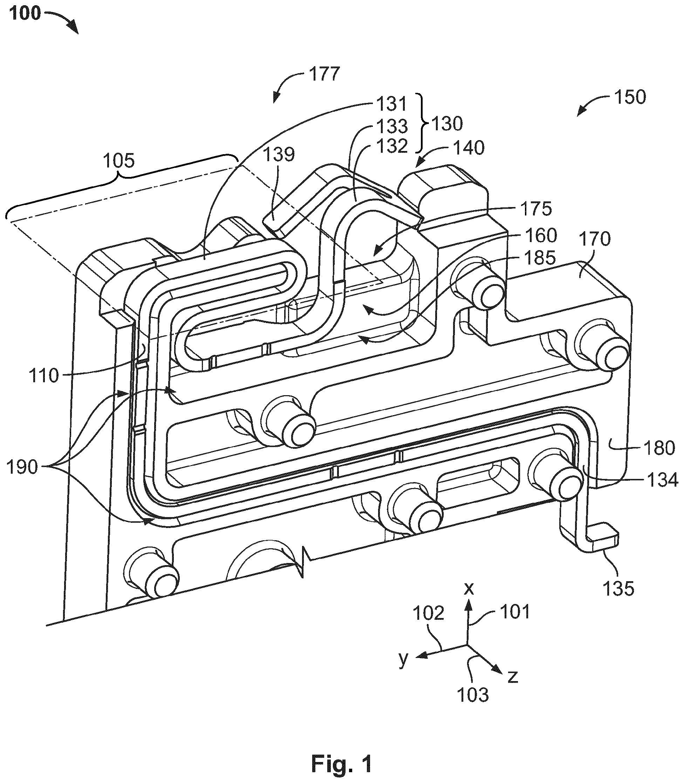

Fig. 1 shows, according to an embodiment, a connector module 100 that includes a terminal 110. The terminal 110 has a contact zone 130. The contact zone 130 can be at a top of the module 100. The contact zone 130 can include at least two separate surfaces for making surface-to-surface conductive electrical contact with a mating connector, e.g. at a top surface of the module 100.

Fig. 1 shows directions, x, y, z for the module 100, according to an embodiment. The module 100 can have an X-direction 101, e.g. the height direction and/or direction of forming electrical contact with another connector; and a Y-direction 102, e.g. the direction of sliding, e.g. when the module 100 is slid into contact with another connector to form an electrical connection. The module 100 can have a Z-direction 103, e.g. a lateral direction. Modules can be mechanically connected together along the lateral direction 103, e.g. to form multi-module connectors with parallel terminals. Multi-module connectors can provide multiple connections to circuit boards. A modular design can provide flexibility to design components in variable configurations, which is advantageous.

The contact zone 130 can include at least one of a first electrical contact surface 131, which can be rigid; a second electrical contact surface 132, which can be elastically movable; and a third surface 133 which can be elastically movable, such as in a height direction 101. For example, the second electrical contact surface 132 and the third surface 133 are movable in the height direction 101. The contact zone 130 can provide multiple surfaces for making electrical contact with another connector. Providing multiple surfaces for electrical contact can reduce the chance of broken electrical connections and/or increase current carrying capacity.

At least two surfaces can be accessible from the top of the module 100, e.g. the surfaces 131, 132, 133. The access from the top can be unobstructed.

The third surface 133 can be used as a protective surface for the first and/or second surfaces 131, 132, for example by making mechanical contact with other components and thereby preventing, in some situations, mechanical contact between the first and/or second surface 131, 132 and the other component. The third surface 133 may be positioned (e.g. extending farther in the height direction 102 than the other surfaces 131, 132) to slide over the other component, while making contact with the other component, when the module 100 is slid into engagement with the other component.

The terminal 110 can be made of a copper alloy, which can provide good conductivity. The terminal 130 can be formed by stamping and bending a sheet, e.g. of a copper alloy that may be plated, e.g. electroplated.

The contact zone 130 can engage another connector, e.g. for forming an electrical connection. The contact zone 130 can be at the top of the module 100.

The connector module can include a housing subassembly 170, e.g. formed of an insulative material, e.g. such as an insulative plate, e.g. with a recessed structure 190 thereon. The housing subassembly 170 can include a wall 180 that includes a recessed structure 190 therein. The recessed structure 190 can hold the terminal 110. The housing subassembly 170 can include an opening 175 through which the terminal 110 extends toward the second contact surface 132 and third surface 133. When the module 100 is in a relaxed state 150, such as shown in Fig. 1, the terminal 110 can extend out of the opening 175, and/or the second electrical contact surface 132 and the third surface 133 are outside of the opening 175 of the housing subassembly 170. The opening 175 can be at a top surface 177 of the housing subassembly 170, e.g. the top surface 177 perpendicular to the wall 180 of the housing subassembly 170.

The surfaces 131, 132, 133 can be exposed at the top surface of the module 100.

The second electrical contact surface 132 and/or the third surface 133 can be elastically movable along a contact direction 101 perpendicular to the sliding direction 102 and perpendicular to the lateral direction 103.

The terminal can include at least one spring section 160 for providing elasticity. The spring section 160 can be connected to the second and/or third surfaces 132, 133. There can be elasticity along the height direction 101 of at least one of the second electrical contact surface 132 and the third surface 133. The elasticity can be provided by the spring section(s) 160. When the contact zone 130 comes into contact, e.g. sliding contact, with another connector, the second electrical contact surface 132 and the third surface 133 can elastically deform, e.g. compress reversibly. Spring operation of electrical contacts can provide robust electrical connections to other devices. The second and third surfaces 132, 133 can be connected to the same spring, which may simplify the design. A stiff connection between the second and third surfaces 132, 133 e.g. both being movable as a unit, can possibly ensure that the third surface 133 can protect the second surface 132, under varying displacement.

The terminal 110 can include a second end 135, e.g. of a conductor 134, that is connectable to a circuit board (not shown in Fig. 1). The second end 135 can be conductively coupled to the contact zone 130 of the terminal 110. For example, the conductor 134 can conductively connect the contact zone 130 to the second end 135.

The conductor 134 can be a serpentine conductor and/or monolithic conductor. Alternatively/additionally, the conductor 134 can include an S shape between the spring section 160 and the first surface 131. The S-shape can aid in providing a neighboring spring and rigid surface, while taking up minimal space. A small and/or compact module can be desirable.

The contact zone 130 can be at a first end of the conductor 134. The conductor 134 can connect the contact zone 130 to a second end 135 of the terminal 110. The second end of the terminal can be for soldering to a face of a circuit board, e.g. the second end 135 is in a position that allows contact to a surface of a circuit board. A serpentine and/or monolithic conductor can simplify manufacturing. For example, the conductor 134 can be prepared from a stamped and bent plate, e.g. a copper alloy plate that may be plated. A serpentine and/or monolithic conductor can be easily manufactured. A serpentine and/or monolithic conductor can be easily placed into a recessed structure 190 of a wall 180 of the housing subassembly 170.

Fig. 1 shows a housing subassembly 170 which can support the terminal 110, e.g. at the wall 180 of the housing subassembly 170. The wall 180 can include the recessed structure 190. The recessed structure 190 can support the terminal 110. The recessed structure 190 can include a partial cavity 185 in which the spring section 160 of the terminal 110 can be located. The partial cavity 185 can provide space for some movement of the terminal 110 such as at the spring portion 160 thereof. The spring portion 160 can be movable in the partial cavity 185. The partial cavity 185 can be connected to the opening 175 through which the terminal 110 extends toward the second contact surface 132 and third surface 133.

The rigidity of the first surface 131 may provided by the material properties, such as thickness, elastic modulus, and/or hardness, of the conductor 134. Alternatively/additionally, the rigidity of the first surface 131 can be provided, at least partially, by the housing subassembly 170, e.g. the housing subassembly's material properties and the housing subassembly's proximity and/or connection to the second surface.

The first surface 131 can be opposite to the top side of the housing subassembly 170 (e.g. the side of the housing subassembly 170 farthest along the x direction 101), e.g. the housing subassembly 170, e.g. top 177 thereof, may abut the terminal 110 on the opposite site of the first surface 131, e.g. to provide firm support such that the first surface 131 is rigid. A first surface 131 with a rigid surface can be used to provide a rigid electrically connecting surface to complementary surface that is elastically movable, e.g. in order to make a robust reversible electrical connection.

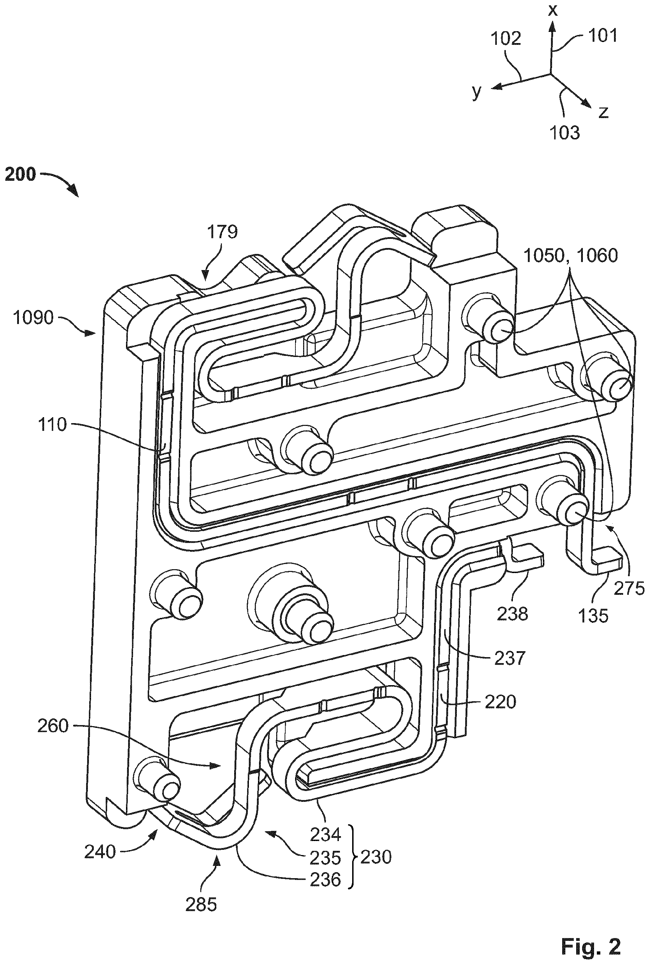

Fig. 2 shows, according to an embodiment, a connector module 200. A connector module 100, 200, such as the connector module 200 shown in Fig. 2, may be formed as a variant of the embodiments described with respect to Fig. 1. A connector module 100, 200 can include a second terminal 220, such as that shown in Fig. 2. The second terminal 220 can include a second contact zone 230 that includes at least one of a fourth electrical contact surface 234 which is rigid, a fifth electrical contact surface 235 which is elastically movable, and a sixth surface 236 which is elastically movable. The fourth, fifth, and sixth surfaces 234, 235, 236 of the second terminal 220 can have the characteristics, as, respectively, the first, second, and third surfaces 131, 132, 133 of the contact zone 130 of the terminal 110.

The terminal 110 and second terminal 220 can be held by the housing subassembly 170, e.g. by the recessed structure 190 of the wall 180. Alternatively/additionally, the recessed structure(s) 190 of the wall 180 can be for holding the terminal(s) 110, 220 and/or providing, respectively, at least partial cavities 185, 285 for spring section(s) 160, 260 of the terminal(s) 110, 220.

The contact zones 130, 230 of the terminals 110, 220 can be symmetric counterparts, e.g. having corresponding and/or similar features to each other. The second contact zone 230 may have the features of the contact zone 130, rotated, e.g. rotated 180° around the z-axis 130. The contact zone 130 can include the opening 175. The second contact zone 230 can, similarly, include a second opening 275.

The second terminal 220 can include a second conductor 237, e.g. that connects the second contact zone 230 to the second end 238 of the second terminal 220. The second end 238 can be connectable to a circuit board, e.g. the same circuit board to which the second end 135 of the terminal 110 is connectable, such as the same face thereof. The rigid fourth electrical contact surface 234 can be supported, as is the first electrical contact 231, by the housing subassembly 170, which may be adjacent and/or abut the opposite side of the second terminal 220 from the fourth contact surface 234 (as can be the case for the first contact 131, housing subassembly 170, and terminal 110).

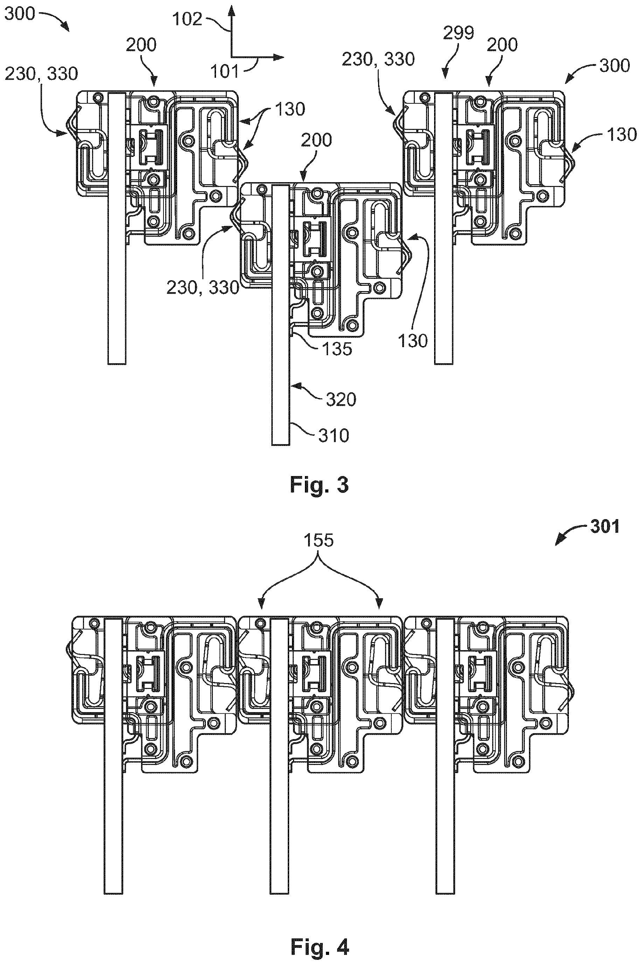

Fig. 3 shows, according to an embodiment, a disengaged connector assembly 299. Fig. 4 shows, according to an embodiment, an engaged connector assembly 301. The connector module(s) 100, 300 such as the connector module 200 shown in Fig. 3 can be connected to a circuit board 310. The second end 135 of the conductor 134 can be solderable to a circuit board 310, e.g. a face 320 of the circuit board 310. The terminal 110 and second terminal 220 of the contact module 200, e.g. that shown in Fig. 2, can be connected to the same face 320 of the circuit board 310, e.g. through the second end 135 of the terminal 110 and the second end 238 of the second terminal 220. The contact zone 130 and second contact zone 230 can each be conductively coupled to the circuit board 310. It can be advantageous to have the contact module 200 be capable of providing contact zones 130, 230 on opposite sides of the same circuit board 310. The contact module 200 can provide for attachment of the circuit board 310 such that the contact zones 130, 230 are on opposite sides of the circuit board 310.

The connector module 100, such as the contact zone 130 thereof, can slidingly engage with another connector and/or connector module 300, such as the complementary contact zone 330 thereof. The engagement can be reversible. The modules 100, 200 described herein, particularly the respective contact zones 130, 230 thereof, can reversibly and slidingly engage, by sliding along a sliding direction 102, a complementary contact zone 330 of another connector 100, 200 (such as the contact zones 230, 130, respectively).

Figs. 3 and 4 show, for example, the contact zones 130, 230 of the module 100 sliding into engagement with the complementary contact zones, 230, 130, respectively, of two other connector modules 100. The complementary connectors and/or modules 300 can be identical to the connector module 100. In the example of Figs. 3 and 4, the second contact zone 230 of the second terminal 220 acts as a complementary contact zone 230 to the contact zone 130 of the terminal 110.

A connector assembly 301 can be formed using identical connector modules 100, 200, or a set that includes connector modules 100, 200 of different types. Alternatively/additionally, a connector assembly 301 can be formed using a module 100, 200 and a connector 300 that includes a complementary contact zone 330, which is complementary to any contact zone 130, 230 of the module 100, 200.

The second electrical contact surface 132 and the third surface 133 can be elastically movable along the contact direction 101 perpendicular to the sliding direction 102 and perpendicular to a lateral direction 103. For example, in Fig. 4, the at least one spring section 160, which can provide elasticity along the contact direction 101 to the second electrical contact surface 132 and/or the third surface 133, is compressed. In Fig. 4, there is electrical contact between the rigid first contact surface 131 of the middle module and the fifth elastic contact surface 235 of the module, or electrically contacting connector module 300, located on the right. The contact zone 130 of the module 100 can make at least two electrical connections to one other connector and/or connector module 300. Providing more than one contact point can aid in ensuring robust electrical contact. Alternatively/additionally, by having one of the surfaces that make contact, for each contact pair, be elastic, adds greater assurance of making robust electrical contact.

The third surface 133 can extend outward along the contact direction 101 farther than the first electrical contact surface 131 and/or the second electrical contact surface 132. The third surface 133 can protect the first and/or second electrical contact surface 131, 132 from mechanical abrasion during the sliding engagement. The third surface 133 can, in an engaged configuration such as shown in Fig. 4, rest in an indentation 179 of the top surface 177 of the housing subassembly 170.

In a relaxed state 150 of the terminal 130 (e.g. see Fig. 1 for illustration), the third contact surface 133 extends outward along the contact direction 101 farther than any of the first electrical contact surface 131 or the second electrical contact surface 132. In the relaxed state 150, the second electrical contact surface 132 can extend outward along the contact direction 101 farther than the first electrical contact surface 131. The outward extension of the second surface 132 can ensure that the second contact surface 132 is compressed upon engagement, and can aid in ensuring a robust electrical contact with a complementary contact surface.

The outward extension of the third surface 133 can aid in protecting the first and/or second contact surface 131, 132 during sliding engagement/disengagement. The third surface 133 can be used such that it does not engage with a complementary conductive counterpart of another connector. The third surface 133, can make sliding contact with, for example, the housing or housing subassembly 170 of the complementary connector (e.g. connectors 300 shown in Fig. 3), such as during sliding engagement, or formation of the (connected) connector assembly 301. The third surface 133, e.g. by extending outward farther than the second 132, can protect the second 132 from abrasions or collection of dust, during sliding engagement. A more robust electrical connection can result between the second contact surface 132 and the mating surface of the other connector and/or connector module 300.

In a compressed state 155 of the terminal 110, such as in an engaged connector assembly 301, shown in Fig. 4, the third electrical contact surface 133 can be closer to an imaginary plane 105 (se Fig. 1) that includes the sliding direction 102 and the first electrical contact surface 131 than in the relaxed state 150. Referring to Fig. 1 for illustration, the imaginary plane 105 can be perpendicular to the contact direction 101. The top face 177 of the housing subassembly 170 can include an indentation 179 (see Fig. 1 for illustration) for receiving the sixth surface 236 and/or a complementary surface which extends outward farther than the complementary conductive surfaces, e.g. fourth and fifth surfaces 235, 234, that make electrical contact, respectively, to the second and first surfaces 132, 131, as shown in Fig. 4.

As can be seen in the embodiments of Figs. 1 and 2, the third surface 133 can extend higher than the first contact surface 131 in the contact direction 101. Such a surface can ensure that the second surface 132 is protected during sliding engagement.

The contact zone 130 can include an inclined surface 140, which, when viewed along the sliding direction 102, inclines upward in the contact direction 101 toward at least one of the second electrical contact surface 132 and the third surface 133. The inclined surface 140 can allow the sliding engagement to operate smoothly. The inclined surface 140 can incline toward the second and/or third surfaces 132, 133 when viewed from either direction along the axis of the sliding direction 102. The inclined surface 140 can provide smooth action when engaging and/or disengaging the connector module 100 with a complementary connector and/or connector module 300. The inclined surface 140 can include a portion of the conductor 134 between the end 139 of the conductor 134 in the contact zone 130 and the third surface 133. The end 139 of the conductor 134 in the contact zone 130 can be lower than the third surface 133. The inclined surface 140 can incline upward from the end 139 to the third surface 133, e.g. viewed along the sliding direction 102.

The inclined surface 140 can include a U-shaped bend, the vertex of the U being on the opposite side of the second and/or third surfaces 133, 134 to the end 139 of the conductor 134.

The second electrical contact surface 132 can be laterally offset from the third surface 133 in the lateral direction 103 perpendicular to the sliding direction 102. Alternatively/additionally, the second electrical contact surface 132 can be vertically offset below the third surface 133 along the contacting direction 101. Such a geometry can ensure that the third surface 133 can act to protect the second surface 132 during sliding engagement/disengagement (see Figs. 3 and 4).

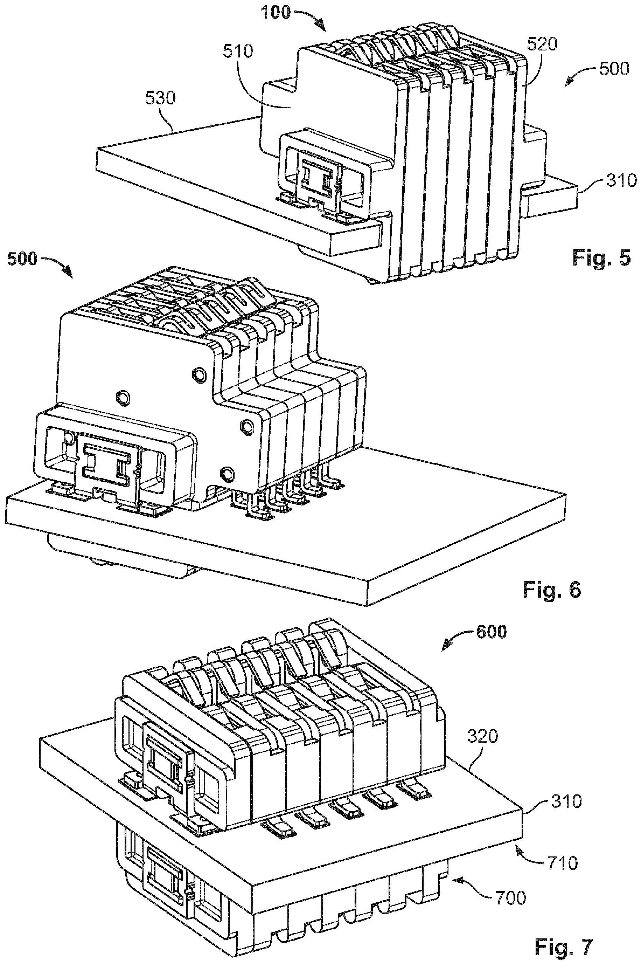

Fig. 5 shows a connector assembly 500, according to an embodiment. A connector assembly 500 can engage with a circuit board 310, e.g. at an edge or notch of the circuit board 310. The connector assembly 500 includes one or more connector modules 100, and end caps 510, 520. The modules 100 can be fit together, with the wall 180 of each housing subassembly 170 of each module 100 abutting an adjacent housing subassembly 170 of an adjacent module 100, or an end cap 510, 520. The end caps 510, 520 can include feet 530 which can attach to the circuit board 310, e.g. by soldering.

Fig. 6 shows, according to an embodiment, the connector assembly 500 of Fig. 5, from a different perspective.

Fig. 7 shows, according to an embodiment, connector assemblies 600, 700. A connector assembly 600, 700 can attach to one side or one face 320 of the circuit board 310. A first connector assembly 600 can attach to a face 320 of the circuit board 310. A second connector assembly 700 can attach to the opposite face 710 of the circuit board 310. Each connector assembly 600, 700 can include one or more connector modules 100, and end caps 510, 520; such as those as described herein. The modules 100 can be fit together, with the wall 180 of each housing subassembly 170 of each module 100 abutting an adjacent housing subassembly 170 of an adjacent module 100, or an end cap 510, 520. The end caps 510, 520 can include feet 530 which can attach to the circuit board 310, e.g. by soldering.

One end cap 520 can be configured to attach to the wall 180 with the recessed structure 190. The other end cap 510 can be configured to attach to the housing subassembly 170 on the other side, e.g. without the recessed structure 190 for holding the terminal(s) 110, 220.

Terminal(s) and/or end cap(s) of the connector assemblies can be soldered to respective faces of the circuit board 310. Contact zones 130, 230 can be located on the opposite side of the module(s) 100 from the circuit board 310.

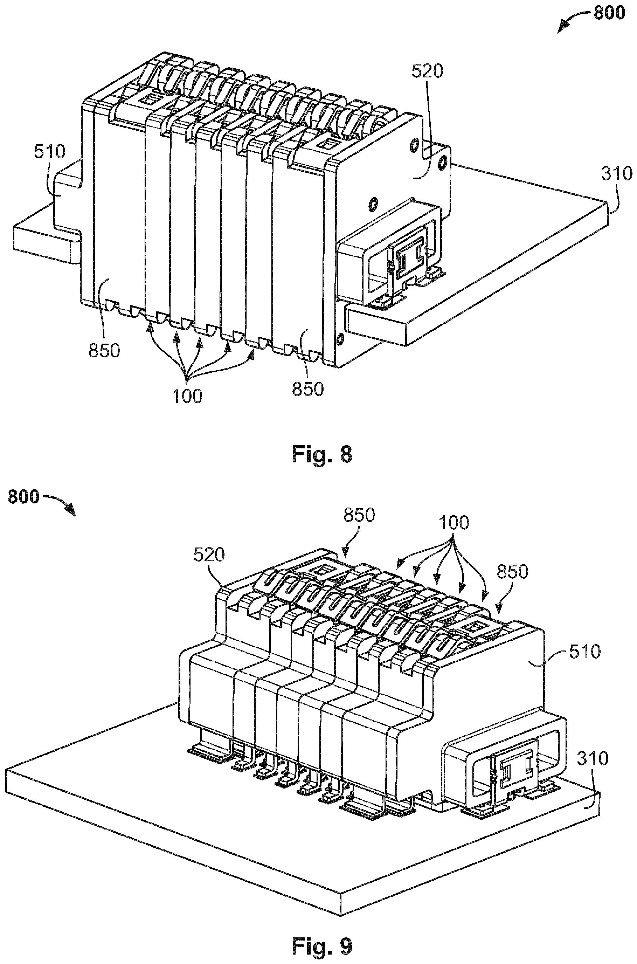

Figs. 8 and 9 show a connector assembly 800 according to an embodiment. A connector assembly can include multiple modules 100, 850. Figs. 8 and 9 show two types of connector modules 100, 850 as part of the assembly 800. The modules 100, 850 can be structurally similar, but have different sized terminals 110. Thicker terminals can be used, e.g. when greater current carrying capacity is desired, such as with module 850 in comparison to module 100. The housing subassembly 170 and/or recessed structure 190 of module 850 for higher current can be adapted, accordingly. For example, the housing subassembly 170 of module 850 can be thicker than the housing subassembly 170 of module 100; and the recesses can be deeper; e.g. to accommodate thicker terminal(s) 110, 220. The end caps 510, 520 can be possibly adjusted.

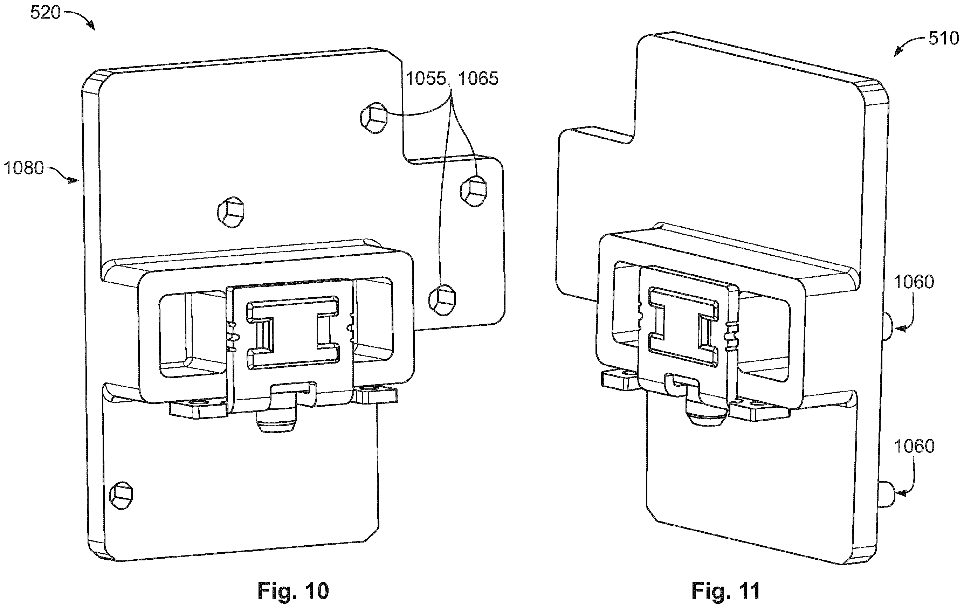

Fig. 10 shows an endcap 520, according to an embodiment. Fig. 11 shows another endcap 510, according to an embodiment. The endcaps 510, 520 can each include a foot 530 for connecting to a circuit board 310, particularly a face 320 of the board 310, e.g. through soldering. The endcaps can include an electrically insulative material, for forming a housing in cooperation with the housing subassembly 170, e.g. for housing and/or holding the terminal(s) 110, 220.

The endcaps 510, 520 can be configured to mechanically mate with a module 100, 200, and vice versa. Structures 1050 of the housing subassembly 170 of the module 100, 200 (see Fig. 2) and complementary structures 1055 of the endcap 520 can fit together, e.g. for forming an interference fit (and/or friction fit). The structures 1050 of the housing subassembly 170 can be, for example posts 1060. The structures 1055 of the end cap 520 can be holes 1065. The structures can be reversed, with holes in the housing subassembly 170 and posts in the end cap 520. The structures can guide the module 100, 200 and end cap 520 for improved alignment. Alternatively/additionally, the structures can provide an interference fit. Alternatively/additionally, an adhesive can possibly be used for attaching the endcaps 510, 520 to the modules 100, 200 and/or for attaching adjacent modules to each other.

The wall 180, such as shown in Fig. 2, can be a structured for mechanical connection and/or friction fitting, e.g. with an opposite structure 1080. For example, the opposite wall 1090 of the housing subassembly 170 (see Fig. 2) can include the opposite structure 1080 (see Fig. 10). For example, the opposite structure 1080 includes holes 1065 (see Fig .10) which complement the posts 1060 of the wall 180. The holes 1065 of the opposite structure 1080 of the housing subassembly 170 are not visible in Fig. 2, as they are on the opposite wall 1090 of the housing subassembly 170.

The opposite structure 1080, which can be the complementary structure to the structure of the wall 180, can be present on the opposite wall 1090 of the module 100, 200 and the endcap 520. For example, posts 1060 can be inserted into holes 1065.

The endcap 510 shown in Fig. 11 has posts 1060. The posts 1060 can be inserted into the holes 1065 of the opposite wall 1090 of the module100, 200.

A connector module 100, 200, in cooperation with a second connector module 100, 200 or endcap 520, can form a housing structure for the terminal(s) 110, 220. The wall 180 of the housing subassembly 170, when connected to a complementary structure, can form a housing structure. The middle section of the conductor(s) 134, 237 can be insulated by the housing structure. The partial cavity 185 can, for example, be housed, leaving the opening(s) 175, 275 through which the terminal(s) 110, 220 can extend.

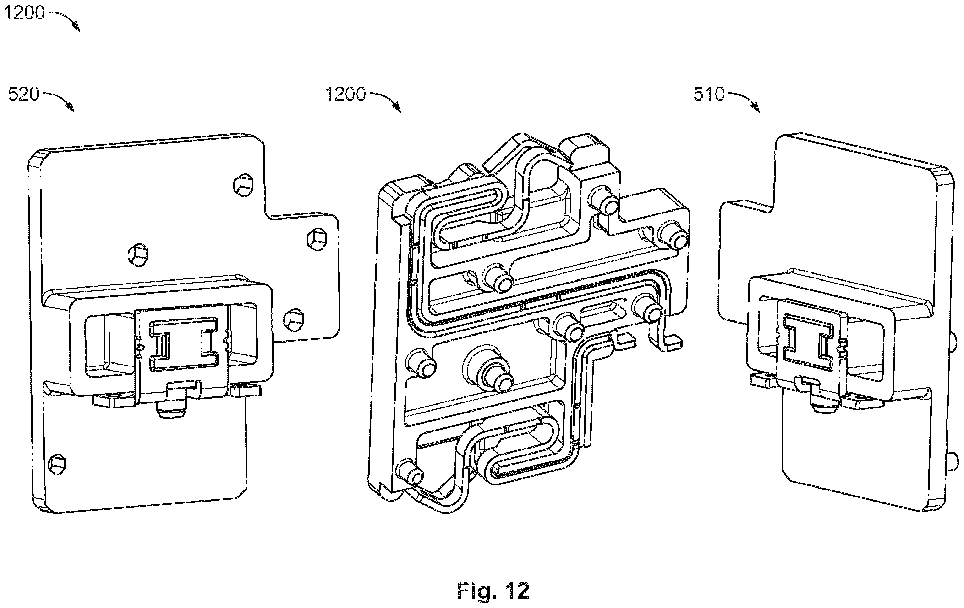

Fig. 12 shows a kit 1200, according to an embodiment. The kit 1200 can be used to form an electrical connector assembly 301, 500, 600, 700, 800, e.g. an assembly that connects to at least one circuit board 310. The kit 1200 can include at least one connector module 100, 200, a first end cap 520 configured to attach to a wall 180 of a housing subassembly 170 of the module 100, 200. The kit can include a second end cap 510 configured to attach to an opposite wall 1090 of the housing subassembly170. The end caps 510, 520 can be configured to form an interference fit with the housing subassembly 170. The kit can provide flexibility for designing the connector assembly 301, 500, 600, 700, 800. The kit 1200 can include more than one type of connector module 100, 200, such as a connector module 850 rated to pass more current than another module 100, 200 of the kit 1200. This may increase flexibility of the design of the connector assembly. Each connector module 100, 850 can have similar structural arrangement of the wall 180 and opposite wall 1090.

The examples described herein are for illustrative purposes.

### REFERENCE NUMERALS

| | |
|---|---|
| connector module | 100 |
| axis; height direction (X), electrical contact direction | 101 |
| sliding direction (Y), depth direction | 102 |
| width direction (Z), lateral direction | 103 |
| imaginary plane | 105 |
| terminal | 110 |
| | |
| contact zone | 130 |
| first electrical contact surface (rigid) | 131 |
| second electrical contact surface (spring) | 132 |
| third surface (spring) | 133 |
| conductor | 134 |
| second end of the conductor | 135 |
| end of the conductor in contact zone | 139 |
| | |
| inclined surface | 140 |
| relaxed state | 150 |
| compressed state | 155 |
| at least one spring section | 160 |
| | |
| housing subassembly | 170 |
| opening | 175 |
| top surface of housing subassembly | 177 |
| indentation in top surface of housing subassembly | 179 |
| wall | 180 |
| partial cavity of housing subassembly | 185 |
| recessed structure of wall | 190 |
| | |
| second connector | 200 |
| second terminal | 220 |
| second contact zone of second terminal | 230 |
| first electrical contact | 231 |
| fourth electrical contact surface (rigid) | 234 |
| fifth electrical contact surface (spring) | 235 |
| fourth contact surface (spring) | 236 |
| second conductor | 237 |
| second end of second terminal | 238 |
| second inclined surface | 240 |
| second opening | 275 |
| second (partial) cavity | 285 |
| disengaged connector assembly | 299 |
| | |
| contacting connector (electrically) (other connector), complementary connector | 300 |
| engaged connector assembly | 301 |
| circuit board | 310 |
| face of the circuit board | 320 |
| complementary contact zone | 330 |
| | |
| connector assembly | 500 |
| other end cap | 510 |
| end cap | 520 |
| foot of end cap | 530 |
| connector assembly | 600 |
| connector assembly | 700 |
| opposite face of circuit board | 710 |
| connector assembly | 800 |
| connector module | 850 |
| | |
| structures of housing subassembly | 1050 |
| posts | 1060 |
| complementary structures | 1055 |
| holes | 1065 |
| opposite structure | 1080 |
| opposite wall of housing subassembly | 1090 |
| kit | 1200 |

## Claims

1. A connector module (100) for contacting an electrically contacting connector (300), comprising:
a terminal (110), including
a contact zone (130) configured for reversibly and slidingly engaging, along a sliding direction (102), the electrically contacting connector (300), particularly a complementary contact zone (330) thereof; wherein
the contact zone (130) includes at least two of:
a first electrical contact surface (131) which is rigid,
a second electrical contact surface (132) which is elastically movable, and
a third surface (133) which is elastically movable.

2. The connector module (100) of claim 1, wherein
the second electrical contact surface (132) and the third surface (133) are elastically movable along a contact direction (101) perpendicular to the sliding direction (102) and perpendicular to a lateral direction (103); wherein optionally
the terminal (130) includes:
at least one spring section (160) for providing elasticity along the contact direction (101) to at least one of the second electrical contact surface (132) and the third surface (133).

3. The connector module (100) of claim 1 or 2, wherein
the third surface (133) extends outward along the contact direction (101) farther than any of:
the first electrical contact surface (131) or the second electrical contact surface (132); wherein optionally
in a relaxed state (150) of the terminal (110),
the third contact surface (133) extends outward along the contact direction (101) farther than any of the first electrical contact surface (131) or the second electrical contact surface (132); and
in a compressed state of the terminal (110),
the third electrical contact surface (133) is closer to an imaginary plane (105) that includes the sliding direction (102) and the first electrical contact surface (131) than in the relaxed state (150); wherein
the imaginary plane is perpendicular to the contact direction (101).

4. The connector module (100) of any one of claims 1-3, wherein
the contact zone (130) includes
an inclined surface (140), which, when viewed along the sliding direction (102), inclines upward in the contact direction (101) toward at least one of the second electrical contact surface (132) and the third surface (133).

5. The connector module (100) of any one of claims 1-4, wherein
the third surface (133) extends higher than the first contact surface (131) in the contact direction (101).

6. The connector module (100) of any one of claims 1-5, wherein
the second electrical contact surface (132) is
laterally offset from the third surface (133) in a lateral direction (103) perpendicular to the sliding direction (102); or
rigidly connected to the third surface (133), such as by a conductor (134)..

7. The connector module (100) of any one of claims 1-6, further comprising
a conductor (134), such as a serpentine conductor and/or monolithic conductor; wherein the contact zone (130) at a first end of the conductor (134) is electrically connected by the conductor (134) to a second end (135) of the conductor (134); wherein optionally the second end (135) is configured for soldering to a face (320) of a circuit board (310); wherein optionally
the second end (135) of the conductor extends out of a second opening (275) of a housing subassembly (170).

8. The connector module (100) of any one of claims 1-7, further comprising:
a second terminal (220), including
a second contact zone (230) for reversibly and slidingly engaging, along the sliding direction (102), with a complementary contact zone (330) of a second connector (200); wherein
the second contact zone (230) includes at least two of:
a fourth electrical contact surface (234) which is rigid,
a fifth electrical contact surface (235) which is elastically movable, and
a sixth surface (236) which is elastically movable.

9. The connector module (100) of claim 8, wherein
the second terminal (220) includes a second end (238) which is configured for soldering to the face (320) of a circuit board (310).

10. The connector module (100) of any one of claims 1-9,
a housing subassembly (170), including
a wall (180) including a recessed structure (190) therein, the recessed structure (190) holding the terminal (110), and optionally
an opening (175) through which the terminal (110) extends toward the second contact surface (132) and third surface (133); wherein optionally
in a relaxed state (150),
the terminal (110) extends out of the opening (175),
the second electrical contact surface (132) and the third surface (133) are outside of the opening (175) of the housing subassembly (170); wherein optionally
the opening (175) is at a top surface (177) of the housing subassembly (170) which is perpendicular to the wall (180); wherein optionally
the housing subassembly (170) includes an electrically insulative material; wherein optionally
a second end (135) of the terminal (110) extends outward from a second opening (275) of the housing subassembly (170), wherein optionally
the second end (135) is configured for soldering to a circuit board.

11. The connector module (100) of claim 10, wherein
the recessed structure (190) includes
a partial cavity (185); wherein
the at least one spring section (160) of the terminal (110) is in the partial cavity (185); wherein optionally
the spring section (160) is movable in the partial cavity (185); wherein optionally
the partial cavity (185) connects to the opening (175).

12. The connector module (100) of claim 10 or 11, wherein
the wall (180) is a structured wall for friction fitting with an opposite structure (1080); wherein an opposite wall (1090) of the housing subassembly (170) includes the opposite structure (1080).

13. A connector assembly (301), comprising,
a first connector module (100, 200) according to any one of claims 1-12, and
a second connector module (200) according to claim 11 or 12, wherein
the first connector module (100) and the second connector module (200) are reversibly electrically mated at the contact zone (130) of the first connector module (100) and a second contact zone (230) of the second connector module (200); wherein
the first and second electrical contact surfaces (131, 132) of the first connector module (100, 200) electrically contact, respectively, the fifth and fourth electrical contact surfaces (235, 234) of the second connector module (200).

14. A connector assembly (500, 600), comprising:
at least one connector module (100, 200) according to any one of claims 1-12;
a first end cap (520) attached to the wall (180); and
a second end cap (510) attached to the opposite side of the assembly (500, 600) from the wall (180); wherein optionally
the end caps (510, 520) are configured to form an interference fit with the housing subassembly (170); wherein optionally
the first end cap (520) and the second end cap (510) include respective feet (530) for attachment to a circuit board (310), such as by soldering.

15. A kit (1200) for forming an electrical connector assembly (301, 500, 600, 700, 800) for connecting to a circuit board (310), comprising
at least one connector module (100, 200) according to any one of claims 1-12; and
a first end cap (520) configured to attach to a wall (180) of a housing subassembly (170) of the module (100, 200); and
a second end cap (510) configured to attach to an opposite wall (1090) of the housing subassembly (170) ; wherein optionally
the end caps (510, 520) are configured to form an interference fit with the housing subassembly (170), such as the wall (180) and opposite wall (1090) thereof.
